Europäisches Patentamt

European Patent Office

Office européen des brevets

(19)

(11) Veröffentlichungsnummer: **0 298 183 B1**

(12) **EUROPÄISCHE PATENTSCHRIFT**

(45) Veröffentlichungstag der Patentschrift: **11.09.91**

(51) Int. Cl.⁵: **G01B 11/00**, G01D 5/36

(21) Anmeldenummer: **87890154.5**

(22) Anmeldetag: **06.07.87**

(54) Inkrementales Lagemesssystem.

(43) Veröffentlichungstag der Anmeldung:
**11.01.89 Patentblatt 89/02**

(45) Bekanntmachung des Hinweises auf die
Patenterteilung:
**11.09.91 Patentblatt 91/37**

(84) Benannte Vertragsstaaten:
**BE CH DE FR GB IT LI LU NL SE**

(56) Entgegenhaltungen:
**EP-A- 0 171 382**
**DE-B- 2 457 376**

(73) Patentinhaber: **RSF-Elektronik Gesellschaft
m.b.H.**

**A-5121 Tarsdorf 93(AT)**

(72) Erfinder: **Rieder, Heinz**
**Riedersbach 90**
**A-5120 St. Pantaleon(AT)**
Erfinder: **Schwaiger, Max**

**A-5121 Ostermiething Nr. 298(AT)**

(74) Vertreter: **Hübscher, Heiner, Dipl.-Ing. et al**
**Spittelwiese 7**
**A-4020 Linz(AT)**

**Beschreibung**

Die Erfindung betrifft ein inkrementales Lagemeßsystem mit wenigstens zwei Gruppen von optoelektronisc hen Abtasteinrichtungen, die zur Erzeugung von wenigstens zwei gegeneinander in der Phase verschobenen Meßsignalen relativ entlang einer Meßteilung verstellbar sind, wobei die Meßsignale einer Vervielfacherschaltung zur elektronischen Unterteilung des Maßstabes und einer Richtungserkennungsstufe zuführbar sind, die ihrerseits Zähl- bzw. Steuersignale für wenigstens einen Vor-Rückwärtszähler erzeugen, dem eine Anzeige- und bzw. oder Steuereinheit nachgeordnet ist und wobei der Zählbeginn und gegebenenfalls das Zählende des Zählers auf vorwählbare Maßstabstellen einstellbar ist wie im Oberbegriff des Anspruchs 1 definiert.

Lagemeßsysteme der gegenständlichen Art können prinzipiell für die Erfassung rotatorischer oder translatorischer Verstellwege verwendet werden, wobei Hauptanwendungsgebiete bei der Winkelmessung und bei der Längenmessung liegen. Man kann aber auch andere physikalische Größen mit Hilfe geeigneter Umsetzeinrichtungen in Lageveränderungen von Abtasteinrichtungen gegenüber einer Meßteilung umsetzen und dann aus dieser Lageveränderung die jeweilige physikalische Größe bestimmen. Ein Anwendungsbeispiel hiefür ist eine Waage mit einer durch den Wiegevorgang relativ gegenüber einer Meßteilung verstellbaren Abtasteinheit. Neben einem ortsfesten Einbau der Meßteilung bzw. Ableseeinheit (die wieder wenigstens aus zwei Abtasteinrichtungen besteht) in Maschinen und Geräten sind auch ortsbewegliche Lagemeßsysteme, z.B. Handgeräte für die Längen- und Winkelmessung bekannt.

Unter anderem kann der Zählbeginn von einem maßstabeigenen Referenzpunkt, von mehreren maßstabeigenen Referenzpunkten oder von gewählten, beispielsweise einem parallel mitlaufenden Hilfszähler, durch Nullsetzen oder Setzen eines bestimmten Zählerinhaltes bestimmten, also nur gespeicherten Referenzpunkt bestimmt werden, der bei Werkzeugmaschinen beispielsweise auf ein Werkstückende oder das Sollwerkstückende nach der Bearbeitung eingestellt wird. Das Zählende kann ebenfalls von einem Referenzpunkt aus gesteuert werden. Feste und gespeicherte Referenzpunkte ermöglichen es, trotz der Inkrementalteilung nach Fehlmessungen, Betriebsstörungen oder Betriebsabschaltungen bestimmte Einstellagen einfach zu reproduzieren.

Eine einfache elektronische Unterteilung des Maßstabes ist beispielsweise dadurch möglich, daß man ein Paar phasenversetzter Meßsignale einer Spannungsteilerschaltung mit einer der erwünschten Anzahl von Zählsignalen entsprechenden Anzahl von Abgriffen zuführt und die Nulldurchgänge der an den Abgriffen erhaltenen Teilsignale auscodiert.

Eine elektronische Unterteilung des Maßstabes ist bisher bis zu einem Verhältnis von 1 : 20 möglich bzw. üblich, so daß man bei einer ohne weiteres reproduzierbaren Inkrementalteilung mit einer Teilungslänge von 0,01 mm (es sind auch Teilungslängen bis 0,004 mm realisierbar) zu einer Messung bzw. Anzeige im Mikrometerbereich und sogar einer Zehnerpotenz darunter gelangen kann. Eine derartig feine Anzeige ist aber nur dann sinnvoll, wenn die erreichbare Meßgenauigkeit der feinen Anzeige entspricht. Entsprechend feine Unterteilungen sind auch bei Winkelmessungen möglich. Abgesehen von hier nicht näher zu behandelnden Unterteilungsfehlern durch nicht exakt eingestellte Phasenabstände der Meßsignale, die an sich durch exakte Einstellung der Abtasteinrichtungen gegeneinander und gegenüber dem Maßstab sowie durch Ausgleichsschaltungen behebbar sind, hängt die Genauigkeit der Unterteilung und damit auch die Genauigkeit der Anzeige davon ab, daß die Signalform des zu unterteilenden Meßsignales sich nicht allzusehr abhängig von der Verstellgeschwindigkeit, der jeweiligen Abtaststelle, von Schwankungen im Versorgungskreis, beispielsweise Schwankungen der Lichtstärke der Beleuchtungseinrichtung bei opto-elektronischer Abtastung, sowie von Schwankungen in der optischen Durchlässigkeit bzw. dem optischen Reflexionsvermögen des Maßstabes und von Abstandsänderungen der Abtasteinrichtungen vom Maßstab ändert. Selbstverständlich können auch Teilungsfehler des Maßstabes oder äußere Störeinflüsse Änderungen der Signalform bzw. sogar Beeinflussungen des Zählers (durch Störsignale) bewirken. Ein Sonderfall des Teilungsfehlers ergibt sich bei Lagemeßsystemen, deren Maßstab wegen leichterer Herstellbarkeit aus mehreren Teilstücken zusammengesetzt ist. Hier wird meist mit zwei wechselweise eingeschalteten, je wenigstens zwei Abtasteinrichtungen enthaltenden Abtasteinheiten gearbeitet und dabei eine wechselweise Einschaltung vorgenommen, so daß jeweils die den Stoßbereich überquerende Abtasteinheit abgeschaltet wird.Es kann praktisch ausgeschlossen werden, daß sich selbst bei genauester Justierung beim Übergang von einer Abtasteinheit auf die andere und von einem Maßstabteilstück auf das andere zum Umschaltzeitpunkt die eine Abtasteinheit exakt in jener Relativstellung zur Inkrementalteilung befindet, wie die andere Abtasteinheit zu dem von ihr abgetasteten Inkrementalteilungsbereich. Ergänzend sei darauf hingewiesen, daß bei opto-elektronischer Abtastung jede Abtasteinrichtung mehrere Teilfelder des Maßstabes durch ein der Maßstabteilung entsprechendes Gitter hindurch abtasten kann. Änderungen der Beleuchtungsstärke der Fototransistoren od.dgl. in Abhängigkeit von der Relativstellung zum Maßstab können auch durch andere Maßnahmen, beispielsweise Linsensysteme, erzeugt werden bzw. es kann sogar mit einem Pulsbetrieb der Beleuchtungseinrichtung und Erzeugung der Zählsignale aus den Pulssignalen gearbeitet werden.

Die aufgezeigten Störeinflüsse können dazu führen, daß während der Durchführung einer Messung Zählimpulse verschluckt oder durch Störeinflüsse Störimpulse eingestreut werden, die als Zählimpulse gezählt werden, wodurch ein Meßfehler auftritt. Besonders bei einem mehrfachen Überqueren stark verschmutzter Maßstabeinheiten oder von Maßstabstoßstellen kann es zu einer Aufsummierung der einzelnen Zählfehler und damit zu größeren Meßfehlern kommen. Es ist zwar möglich und auch üblich, einzelne Messungen zu wiederholen und vor jeder Einzelmessung eine Neujustierung des Zählers durch Anfahren eines Bezugspunktes vorzunehmen, doch sind hier an sich wenigstens drei Messungen, bei denen das Ergebnis von wenigstens zweien übereinstimmt, notwendig. Wird allerdings bei diesen Messungen eine besondere Fehlerquelle, beispielsweise ein Stoßbereich von Maßstabteilstücken, jeweils gleich oft überquert, kann auch in dem übereinstimmenden Meßergebnis ein systematischer Zählfehler enthalten sein.

Die Praxis zeigt, daß Zählfehler auch richtungsabhängig verschieden groß auftreten können. Beispielsweise kommt es bei der Spaltüberquerung und Systemumschaltung manchmal in der einen Verstellrichtung zu einem anderen Zählfehler als in der anderen Verstell- bzw. Umschaltrichtung. Wenn die möglichen Zählfehler größenordnungsmäßig bei einer Messung gleich oder größer werden als das Äquivalent einer Meßteilung, dann ist an sich die elektronische Unterteilung der Meßsignale sinnlos bzw. es wird durch diese Unterteilung eine tatsächlich nicht vorhandene Genauigkeit vorgetäuscht.

Aufgabe der Erfindung ist die Schaffung eines Lagemeßsystemes, mit dessen Hilfe auftretende Zählfehler erkannt und angezeigt bzw. korrigiert werden können und zumindest eine Summierung auftretender Zählfehler verhindert wird.

Bei einem Lagemeßsystem der eingangs genannten Art wird die gestellte Aufgabe dadurch gelöst, daß eine von den Meßsignalen und den Zählsignalen beaufschlagte Überwachungsschaltung vorgesehen ist, die einen an den Zählsignalen liegenden Korrekturzähler, einen Sollwertspeicher und einen Vergleicher aufweist und daß der Vergleicher vom Nulldurchgang wenigstens des einen Meßsignales beaufschlagt, den Zählerstand des Korrekturzählers mit dem gespeicherten Sollwert vergleicht und bei Abweichungen Korrektursignale für die Zählschaltung bzw. eine eigene Korrekturstufe in der Zählschaltung erzeugt oder eine Alarmeinrichtung einschaltet. Der Sollwert kann dem Abstand der Abtasteinheit von dem in Verstellrichtung folgenden Ende der Maßstabteilung (Inkrement) entsprechen, auf dem die Zählung begonnen hat. Selbstverständlich können entsprechende Sollstände auch zu folgenden Trennpunkten der Maßstabteilung (Übergang von einem auf das nächste Inkrement) bestimmt und verglichen werden. Vorzugsweise wird der Stand der niedrigsten Zähldekade bzw.-dekaden des Zählers mit einem gespeicherten Sollwert verglichen, der, da die Zählung keineswegs zwangsweise in der Mitte einer Teilung beginnt, für die beiden Zählrichtungen verschieden sein kann.

Dem Korrekturzähler kann für die letztere Möglichkeit ein Speicher zum Festhalten des beim Nulldurchgang aufgetretenen Zählstandes nachgeordnet sein, dessen Inhalt auf den Vergleicher abrufbar ist. Hier wird den praktischen Erfordernissen Rechnung getragen, bei denen ja durch die Verstellung der Abtasteinheiten gegenüber der Meßteilung fortlaufend Zählsignale auftreten. Der im Augenblick des Nulldurchganges erhaltene Momentanwert des Zählstandes wird im Speicher festgehalten und verarbeitet, wobei die Korrektur verzögert folgt. Man kann auch die Zählsignale verzögern, dem Vergleicher zuführen und dann die Korrektur vornehmen, so daß die Korrektur vor dem nächsten Nulldurchgang beendet wird, wenn weiterhin eine Meßverstellung auftritt. Im Normalfall ist, wie erwähnt, im Sollwertspeicher der Überwachungsschaltung ein dem Inkrementbruchteil der Meßteilung zwischen Einschaltpunkt des Abtastsystems und nächstem Teilungsfeldende entsprechender Wert gespeichert.

Der Sollwertspeicher kann weiters über die steuereinrichtung in vorbestimmten Betriebszuständen, insbesondere nach dem Auftreten einer bestimmten Anzahl von Korrekturbefehlen (Nulldurchgänge des Meßsignales) mit dem Inhalt des Zwischenspeichers beaufschlagbar sein.

Um zu verhindern, daß ein zufällig im ersten überwachten Inkrementbruchteil vorhandener Teilungsfehler oder ein beispielsweise durch das Umschalten von einem Meßsystem auf das andere auftretender, als Zählimpuls registrierter Störimpuls zur Speicherung eines falschen Korrekturwertes führt, kann der zuletzt erwähnte Zwischenspeicher als Durchschnittsbildner für mehrere Zählfolgen des Korrekturzählers ausgebildet sein.

Der Korrekturzähler kann als Überlaufzähler ausgeführt sein, dessen Zählstufenzahl der elektronischen Maßstabunterteilung, also dem die Anzahl der Zählimpulse ergebenden Vielfachen der Meßimpulse bzw. Meßsignale entspricht.

Bei der Korrektur können die Hinzufügung bzw.

Wegnahme von Zählimpulsen ermöglichende Korrekturstufen vor der Richtungserkennungsstufe in den Zählimpulsleitungen liegen.

Für den Sonderfall eines Lagemeßsystemes mit einem aus mehreren Teilstücken bestehenden Maßstab und zwei in Maßstablängsrichtung versetzten, je wenigstens zwei Abtasteinrichtungen enthaltenden Abtasteinheiten, die über einen Umschalter, der jeweils die den Stoß zwischen zwei Teilstücken überquerende Abtasteinheit abschaltet, wechselweise einschaltbar sind, kann man erfindungsgemäß jedem Maßstabteilstück gesonderte Speicherplätze im Sollwertspeicher zuordnen und die einem Maßstabteilstück zugeordneten Speicherplätze vom Umschalter gesteuert mit der Vergleichseinrichtung verbinden. Vorzugsweise wird der Speicher ringförmig organisiert, wobei jedem Maßstabteilstück gesonderte Speicherplätze für beide Abtastrichtungen zugeordnet sind, die bei der jeweiligen Abtastrichtung mit der Vergleichseinrichtung verbindbar sind.

Weitere Einzelheiten und Vorteile des Erfindungsgegenstandes gehen aus der nachfolgenden Zeichnungsbeschreibung hervor.

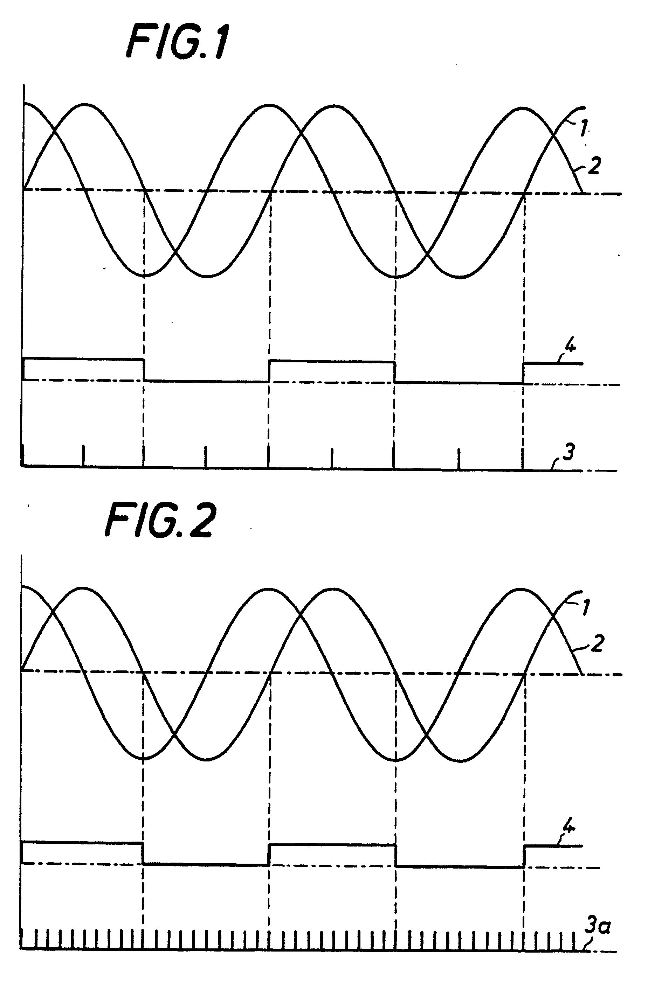

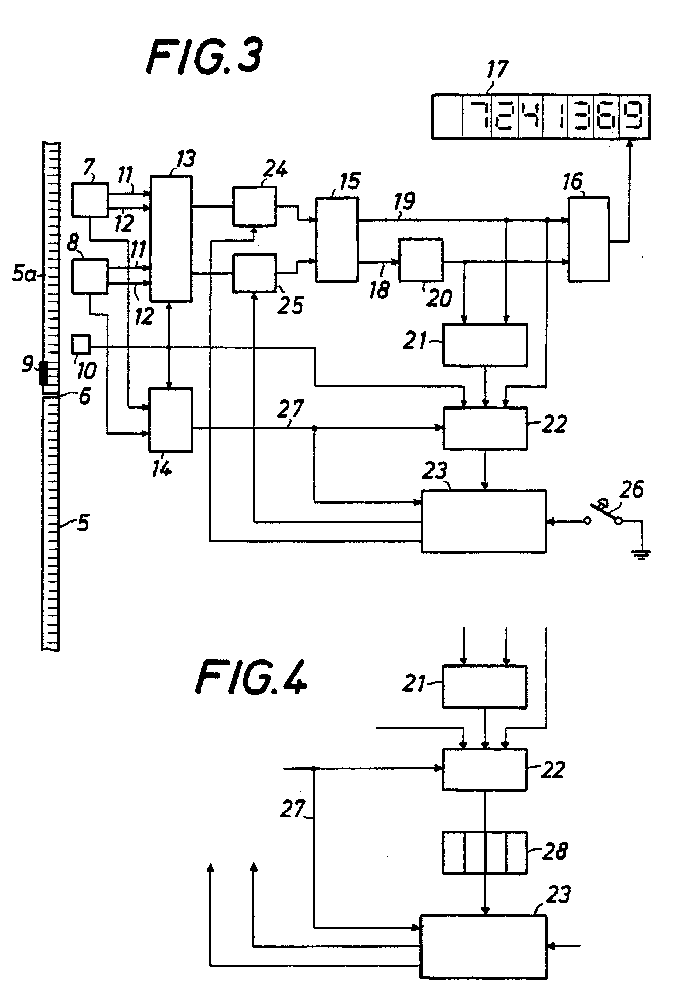

In der Zeichnung ist der Erfindungsgegenstand beispielsweise veranschaulicht. Es zeigen: Fig. 1 und 2 zwei Diagramme zur Erläuterung des Prinzips der Korrektur beim erfindungsgemäßen Lagemeßsystem, Fig. 3 ein Prinzipschaltschema eines erfindungsgemäßen Lagemeßsystems und Fig. 4 eine Schaltungsvariante zu Fig. 3.

Bei den Ausführungsbeispielen wird von verhältnismäßig einfachen Lagemeßsystemen ausgegangen. Nach den Fig. 1 und 2 wird angenommen, daß durch Abtastung eines Inkrementalmaßstabes mit zwei Gruppen optoelektronischer Abtasteinrichtungen bei der Relativverstellung der Abtasteinrichtungen gegenüber der Meßteilung durch Zusammenschaltung der einzelnen Empfänger der Abtasteinrichtungen zwei im Idealfall sinus- bzw. kosinusförmige Signale erhalten werden, die als Meßsignale bezeichnet werden, da ihre Wellenlänge der Maßstabteilung entspricht. Die beiden Signale 1 und 2 sind gegeneinander im Idealfall um 90° versetzt. Da immer ein Signal dem anderen in einer Richtung voreilt, kann man aus den beiden Signalen auch die relative Verstellrichtung der Abtasteinheit gegenüber dem Maßstab bzw. der Meßteilung mit Hilfe geeigneter Schaltungen feststellen. Die Abstände der Nulldurchgänge jedes Signales entsprechen der Breite der halben Meßteilung, also der Länge eines Hell- bzw. Dunkelfeldes bei optoelektronischen Meßeinrichtungen. Da man zwei um 90° gegeneinander versetzte Signale zur Verfügung hat, kann man nach Fig. 1 durch Auswertung der Nulldurchgänge beider Signale 1 und 2 und Erzeugung eines Zählsignales beim jeweiligen Nulldurchgang aus den beiden Meßsignalen für jedes Maßstabteilstück vier in der Linie 3 dargestellte Zählsignale ableiten. Durch eine Vervielfacherschaltung kann man aber aus den beiden Meßsignalen auch gemäß Fig. 2 eine Vielzahl von Zählsignalen (auf der Linie 3a dargestellt) gewinnen. Beim Ausführungsbeispiel wurde angenommen, daß für die einer vollständigen Wellenlänge entsprechenden Meßteilung zwanzig Zählimpulse erzeugt werden.

Bei richtiger Messung müssen die zwischen zwei Nulldurchgängen eines Meßsignales 1 oder 2 auftretenden Zählimpulse einen bestimmten, festen Wert ergeben. Weicht dieser Wert vom Sollwert ab, so ist ein Zählfehler aufgetreten. Man kann nun aus den Nulldurchgängen des einen der beiden Meßsignale 1 oder 2 ein Prüfsignal 4 erzeugen und jeweils beim Nulldurchgang überprüfen, ob der Sollwert an Zählimpulsen erreicht ist oder nicht. Beginn die Zählung bei Null, so entspricht der Sollwert dem Unterteilungswert der Meßsignale. Es ist aber auch ohne weiteres möglich und im Normalfall üblich, bei einem beliebigen Setzen des Zählbeginnes mit der Zählung nicht am Nulldurchgang des Bezugs-Meßsignales (in Fig. 1 und 2 das Signal 1), sondern an beliebiger Stelle zu beginnen. Hier müssen bis zum nächsten Nulldurchgang in beiden Zählrichtungen (Verstellrichtungen von Abtasteinrichtung und Maßstab) je eine bestimmte Anzahl von Zählimpulsen auftreten, wenn kein Zählfehler bzw. keine Störung vorliegt. Der Einfachheit halber wird immer nur von Zählimpulsen gesprochen, doch sind hier auch Störungen des Vor-Rückwärtszählers durch äußere Störeinflüsse, die zum Verschlucken von Zählimpulsen oder zum Vortäuschen von Zählimpulsen führen, gemeint. Jedenfalls erhält man durch den Nulldurchgang eine eindeutige Bezugsstelle, an der der Sollzählstand festgestellt werden kann. Tritt ein Fehler auf, dann kann eine Alarmeinrichtung betätigt oder über Korrekturschaltungen eine Berichtigung des Hauptzählerstandes vorgenommen werden. Eine geeignete Schaltung ist in dem in den Fig. 3 und 4 näher beschriebenen Lagemeßsystem vorgesehen.

Das Lagemeßsystem nach den Fig. 3 und 4 arbeitet mit einer Meßteilung, die auf mehreren Maßstabteilstücken 5, 5a angebracht ist, von denen zwei dargestellt wurden. Zwischen den Maßstabteilstücken liegt ein Stoßbereich 6, dessen Größe sich kaum genau definieren läßt und die nur zufällig einem ganzzahligen Vielfachen der auf den Maßstabteilstücken angebrachten inkrementalen Meßteilung, der im einfachsten Fall aus gleich langen hellen und dunklen Feldern besteht, entsprechen wird.

Für die Abtastung des Maßstabes sind zwei optoelektronische Abtasteinheiten 7, 8 vorgesehen, die je eine Beleuchtungseinrichtung und vier über gegeneinander versetzte Gitter die Maßstabteilung abtastende Fototransistoren od.dgl. enthalten, so daß jede der Abtasteinheiten 7 und 8 in der Lage ist, zwei Meßsignale 1, 2 nach den Fig. 1 und 2 zu erzeugen. Am Maßstabteilstück 5a ist eine Steuermarke 9 vorhanden, mit der eine weitere Abtasteinheit 10 zusammenwirkt und jeweils einen Umschaltbefehl erzeugt, durch den in weiterer Folge von den beiden wechselweise einschaltbaren Abtasteinheiten 7, 8 jeweils die den Spalt 6 überquerende Einheit abgeschaltet wird. Entsprechende Einrichtungen sind beispielsweise aus dem eigenen CH-Patent 617 006 bekannt. Die Meßsignale 1, 2 werden über Leitungen 11, 12 einer Vervielfacherschaltung 13 zugeführt. Die Abtasteinheiten 7 und 8 sind ferner mit einem auf den Nulldurchgang des Signales 1 empfindlichen Steuerschalter 14 verbunden. Von der Schaltung 13 gelangen die Zählimpulse 3 bzw. 3a zu einer der Richtungserkennung und Impulszusammenführung dienenden Steuerstufe 15, die in weiterer Folge die Zählimpulse und ein Richtungssignal einem Vor-Rückwärtszähler 16 zuführt, der beispielsweise eine Anzeige 17 steuert, gegebenenfalls aber auch Teil einer Maschinensteuereinrichtung sein kann. Soweit bisher beschrieben wurde, ist die Einrichtung (mit Ausnahme der Stufe 14) bekannt. Auf der Leitung 18 liegen die Zählimpulse und auf der Leitung 19 das die Zählrichtung des Vor-Rückwärtszählers 16 bestimmende Signal.

Der Steuerschalter 14 ist Bestandteil einer Überwachungs- und Korrekturschaltung mit einem in der Leitung 18 liegenden Verzögerungsglied 20, einem Hilfszähler 21, einem diesem zugeordneten Speicher 22 und einer Steuereinrichtung 23, die ihrerseits einen Sollwertspeicher enthält. Vor der Steuerstufe 15 liegen in dem von der Vervielfacherschaltung 13 kommenden Leitungen Korrekturstufen 24, 25, von denen die eine (24) für die Zugabe und die andere (25) für die Wegnahme von Zählimpulsen dient.

Der Hilfs- oder Korrekturzähler 21 ist als Überlaufzähler mit einem dem Sollwert der Zählsignale zwischen zwei Nulldurchgängen des Signales 1 entsprechenden Inhalt ausgebildet, d.h. er stellt beim Erreichen des Sollwertes auf "Null".

Zu Beginn einer Messung werden die Zähler 16 und 21 mit Hilfe eines Nullsetz- oder Vorwählschalters 26, der schematisch an der Steuereinrichtung 23 angedeutet wurde, aber auch eine der Abtasteinheit 10 ähnliche, auf eine Maßstabmarkierung ansprechende Abtasteinheit sein kann auf "Null" oder einen bestimmten Wert gesetzt, wobei aber im Normalfall der Hilfszähler 21 immer auf Null gesetzt wird. Erfolgt nun die Messung (Verstellung der Abtasteinheiten 7, 8 gegenüber der Meßteilung 5, 5a), so zählt der Zähler 16 entsprechend der vorgegebenen Meßrichtung, die ihm über die Leitung 19 angegeben wird, die über 18 eintreffenden Zählimpulse (3 oder 3a) und die Anzeige 17 wird entsprechend gestellt. Der ebenfalls richtungsabhängig zählende Korrekturzähler zählt ebenfalls die Zählsignale. Diese Signale werden zunächst auf den Speicher 22, der ein verriegelbares Schieberegister sein kann, das bei jedem einlangenden Zählimpuls um einen Schritt weiterschiebt, gelegt. Beim Nulldurchgang des Signales 1 wird der Speicher 22 verriegelt (der Nullimpuls wird als Latchimpuls verwendet) und gleichzeitig erhält die Einheit 23 einen Steuerbefehl von der Ausgangsleitung 27 des Steuerschalters 14, so daß sie den Inhalt ihres Speichers mit dem Inhalt des verriegelten Speichers 22 vergleicht. Stimmen die Speicherinhalte überein, wird die Verriegelung wieder aufgehoben. Bei Abweichungen vom Sollwert wird, je nachdem, ob der Sollwert über oder unter dem gespeicherten Zählwert des Überwachungszählers 21 liegt, die Korrekturstufe 24 oder 25 betätigt, die zwischen zwei regulären Zählimpulsen einen zusätzlichen, in weiterer Folge als Zählimpuls gewerteten Impuls einschiebt oder den nächstfolgenden Zählimpuls unterdrückt. Da die Korrekturstufen vor der Einheit 15 angeordnet sind, erfolgt eine richtungsabhängige Korrektur. Die Steuereinrichtung 23 ist vorzugsweise als programmierter Mikroprozessor ausgebildet und enthält einen ringförmig organisierten (RAM-)Speicher mit mehreren Speicherplätzen. Wird über 9-10 von einer auf die andere Abtasteinheit 7 bzw. 8 umgeschaltet bzw. läßt sich aus der Reihenfolge der Steuerbefehle entnehmen, daß nun ein neues Maßstabteilstück befahren wird, dann wird auf den nächsten Speicherplatz umgeschaltet. Dieser Speicherplatz ist mit einem neuen Korrekturwert belegt oder beim erstmaligen Befahren des entsprechenden Maßstabteilstückes während dieser Messung zu belegen. Ist eine Neubelegung notwendig, wird zweckmäßigerweise nach dem zweiten, dritten oder einem folgenden Nulldurchgang aus der Abtastung dieser Maßstabteilstrecke ein entsprechender Korrekturwert am Speicher 22 abgelesen und in den jeweiligen Speicherplatz der Steuereinrichtung 23 übernommen. Es wird hier von der Annahme ausgegangen, daß der am ersten Nulldurchgang auftretende Stand des Zählers 21 noch mit Fehlern behaftet sein kann. Man kann auch Speicherplätze für jede der beiden Verstellrichtungen vorsehen. Zumindest für die jeweilige Messung ist jedem Maßstabteilstück, 5, 5a usw. im Speicher des Mickroprozessors 23 (Steuereinrichtung) wenigstens ein Korrekturwert bzw. zwei richtungsabhängige Korrekturwerte zugeordnet, die beim jeweiligen Neubefahren des entsprechenden Maßstabteilstückes jeweils beim Nullimpuls abgerufen und mit dem Zählerstand des Korrekturzählers 21 verglichen werden. Fig. 4 zeigt eine Schaltungsvariante, bei der zwischen dem Speicher 22 und der Steuereinrichtung 23 ein Durchschnittsbildner 28 angeordnet ist, der zunächst aus mehreren, am Nulldurchgang bei der jeweiligen Zählrichtung und am jeweiligen Maßstabteilstück festgestellten Zählerständen einen Durchschnitt bildet, d.h. den am häufigsten vorkommenden Zählerstand festhält, und dann erst diesen Wert als Korrekturwert an den Speicher der vom Mikroprozessor gebildeten Steuereinrichtung 23 abgibt. Der Speicher 22 wird bei jedem Steuerimpuls von 10 und bei jeder Zählrichtungsänderung gelöscht.

Die Erfindung kann selbstverständlich auch bei Lagemeßsystemen mit kreis- oder bogenförmigen Maßstäben (Winkelmeßsystemen) verwendet werden. Das Korrekturverfahren ist prinzipiell auch bei inkrementalen Lagemeßsystemen mit magnetischer, induktiver oder kapazitiver Abtastung anwendbar.

## Patentansprüche

1. Inkrementales Lagemeßsystem mit wenigstens zwei Gruppen (7,8) von opto-elektronischen Abtasteinrichtungen, die zur Erzeugung von wenigstens zwei gegeneinander in der Phase verschobenen Meßsignalen (1, 2) relativ entlang einer Meßteilung (5, 5a) verstellbar sind, wobei die eine der Meßteilung entsprechende Wellenlänge aufweisenden Meßsignale (1, 2) einer Vervielfacherschaltung (13) zur elektronischen Unterteilung des Maßstabes und einer Richtungserkennungsstufe (15) zuführbar sind, die ihrerseits Zähl-bzw. Steuersignale für einen Vor-Rückwärtszähler (16) erzeugen, dem eine Anzeige- und bzw. oder Steuereinheit nachgeordnet ist und wobei der Zählbeginn und gegebenenfalls das Zählende des Zählers (16) auf vorwählbare Meßteilungsstellen einstellbar ist, dadurch gekennzeichnet, daß eine von den Meßsignalen (1, 2) und den Zählsignalen (3, 3a) beaufschlagte Überwachungsschaltung (14, 20 - 28) vorgesehen ist, die einen an den Zählsignalen liegenden Korrekturzähler (21), einen Sollwertspeicher und einen Vergleicher (23) aufweist und daß der Vergleicher (23) vom Nulldurchgang wenigstens des einen Meßsignales (1) beaufschlagt, den Zählerstand des Korrekturzählers mit dem gespeicherten Sollwert vergleicht und bei Abweichungen Korrektursignale für die Zählschaltung (15,16,17) bzw. eine eigene Korrekturstufe (25, 26) in der Zählschaltung erzeugt oder eine Alarmeinrichtung einschaltet.

2. Lagemeßsystem nach Anspruch 1, dadurch gekennzeichnet, daß dem Korrekturzähler (21) ein Speicher (22) zum Festhalten des beim Nulldurchgang aufgetretenen Zählstandes nachgeordnet ist, dessen Inhalt auf den Vergleicher (23) abrufbar ist.

3. Lagemeßsystem nach Anspruch 1 oder 2, dadurch gekennzeichnet, daß im Sollwertspeicher der Überwachungseinrichtung (23) ein dem Inkrementbruchteil der Meßteilung zwischen Einschaltpunkt des Abtastungssystems und nächstem Teilungsfeldende entsprechender Wert gespeichert ist.

4. Lagemeßsystem nach Anspruch 3, dadurch gekennzeichnet, daß der Sollwertspeicher über die Steuereinrichtung (23) in vorbestimmten Betriebszuständen, insbesondere nach dem Auftreten einer bestimmten Anzahl von Korrekturbefehlen (Nulldurchgängen des Meßsignales) mit dem Inhalt des Zwischenspeichers (22 bzw. 28) beaufschlagbar ist.

5. Lagemeßsystem nach Anspruch 4, dadurch gekennzeichnet, daß der Zwischenspeicher (22, 28) als Durchschnittsbildner für mehrere Zählungen des Korrekturzählers (21) ausgebildet ist.

6. Lagemeßsystem nach einem der Ansprüche 1 bis 5, dadurch gekennzeichnet, daß der Korrekturzähler (21) als Überlaufzähler ausgebildet ist, dessen Zählstufenzahl der elektronischen Maßstabunterteilung, also dem die Anzahl der Zählimpulse ergebenden Vielfachen der Meßimpulse entspricht.

7. Lagemeßsystem nach einem der Ansprüche 1 bis 6, dadurch gekennzeichnet, daß die Hinzufügung bzw. Wegnahme von Zählimpulsen ermöglichende Korrekturstufen (24, 25) vor der Richtungserkennungsstufe (25) in den Zählimpulsleitungen liegen.

8. Lagemeßsystem nach einem der Ansprüche 1 bis 7, mit einem aus mehreren Teilstücken bestehenden Maßstab und zwei in Maßstablängsrichtung versetzten, je wenigstens zwei Abtasteinrichtungen enthaltenden Abtasteinheiten, die über einen Umschalter, der jeweils die den Stoß zwischen zwei Teilstücken überquerende Abtasteinheit abschaltet, wechselweise einschaltbar sind, dadurch gekennzeichnet, daß jedem Maßstabteilstück (5, 5a) gesonderte Speicherplätze im Sollwertspeicher (23) zugeordnet und die einem Maßstabteilstück zugeordneten Speicherplätze vom Umschalter (10) gesteuert, mit der Vergleichseinrichtung (22, 23) verbindbar sind.

9. Lagemeßsystem nach Anspruch 8, dadurch gekennzeichnet, daß jedem Maßstabteilstück (5, 5a) im Sollwertspeicher gesonderte Speicherplätze für beide Abtastrichtungen zugeordnet sind, die bei der jeweiligen Abtastrichtung mit der Vergleichseinrichtung (22, 23) verbindbar sind.

## Claims

1. An incremental locating system having at least two groups (7, 8) of opto-electronic scanning means adjustable along a measurement scale and adapted to produce at least two non-cophasal measurement signals (1, 2), one of the measurement signals (1, 2), the same having a wavelength corresponding to the scale graduation, being adapted to be supplied to a multiplier circuit arrangement (13) for electronic scale subdivision and to a direction-identifying stage (15) which produce counting or control signals for a forwards and backwards counter (16) which is followed by a display and/or control unit, the start of counting and possibly the end of counting of the counter (16) being adjustable to preselectable places on the scale, characterised in that a monitoring circuit arrangement (14, 20 - 28) actuated by the measurement signals (1, 2) and the counting signals (3, 3a) is provided and has a correction counter (21) connected to the counting signals, a set-value store and a comparator (23), and the same responds to the passage through zero of at least one measurement signal (1) by comparing the state of the correction counter with the stored set value, and in the event of deviations, by producing correction signals for the counting circuit arrangement (15 - 17) or for an independent correction stage (25, 26) therein or by actuating warning means.

2. A system according to claim 1, characterised in that a store (22) for retaining the counter state associated with the passage through zero is disposed after the correction counter (21) and the content of the latter store can be called up to the comparator (23).

3. A system according to claim 1 or 2, characterised in that a value corresponding to the incremental function of the measuring scale between the switch-on point of the scanning system and the next graduation boundary is stored in the set-value store of the monitor means (23).

4. A system according to claim 3, characterised in tht the set-value store is adapted to be actuated with the content of the intermediate store (22; 28) by way of the control means (23) at predetermined operative states, more particularly after the appearance of a predetermined number of correction instructions (passages of the measurement signal through zero).

5. A system according to claim 4, characterised in that the intermediate store (22, 28) is an average former for a number of counts of the correction counter (21).

6. A system according to any of claims 1 to 5, characterised in that the correction counter (21) is an overflow counter whose number of counting stages corresponds to the electronic scale subdivision - i.e., to that multiple of the measuring pulses which produces the number of counting pulses.

7. A system according to any of claims 1 to 6, characterised in that correction stages (24, 25) enabling counting pulses to be added or removed are disposed in the counting pulse lines before the direction-identifying stage (25).

8. A system according to any of claims 1 to 7 having a scale comprising a number of components and two scanning units which are offset lengthwise of the scale and which each comprise at least two scanning means and which can be energised alternately by way of a selector which switches off the scanning unit bridging the gap between two components, characterised in that special storage places in the set-value store (23) are associated with each scale component (5, 5a) and the storage places associated with one scale component can be connected under the control of the selector (10) to the comparator (22, 23).

9. A system according to claim 8, characterised in that separate storage places for both scanning directions are associated with each scale component (5, 5a) in the set-value store and are adapted to be connected to the comparator (22, 23) in the particular scanning direction concerned.

## Revendications

1. Système incrémental de mesure de la position comprenant au moins deux groupes (7,8) de dispositif de lecture optoélectronique pouvant être déplacés le long d'une échelle de mesure (5,5a) pour produire au moins deux signaux de mesure (1,2) déphasés l'un par rapport à l'autre, les signaux de mesure (1,2) ayant une longueur d'onde correspondant à la division de l'échelle graduée pouvant être transmis à un circuit multiplicateur (13), pour diviser l'échelle de façon électronique, et a un étage détecteur de direction (15), qui peuvent produire des signaux de comptage et de commande respectivement pour un compteur - décompteur (16), qui est suivie par une unité d'affichage et/ou unité de commande, et le début de comptage et, le cas échéant, la fin de comptage du compteur (16) pouvant être ajustés sur des points de l'échelle graduée pouvant être sélectionnés d'avance, caractérisé en ce qu'un circuit de contrôle (14,20-28) recevant les signaux de mesure (1,2) et les signaux de comptage (3,3a) est prévu et comprend un compteur de correction (21) recevant les signaux de comptage, une mémoire de valeur désirée et un comparateur (23), et que le comparateur (23) ayant reçu au moins le passage par zéro d'un signal de mesure (1) compare le contenu du compteur de correction avec la valeur désirée mémorisée et produit des signaux correcteurs pour le circuit de comptage (15,16,17) respectivement pour un étage correcteur (25,26) propre dans le circuit de comptage ou met en marche un dispositif d'alarme.

2. Système de mesure de la position selon la revendication 1, caractérisé en ce que le compteur de correction (21) est suivie par une mémoire (22) pour retenir le contenu du compteur présent au moment du passage par zéro et dont le contenu peut être lu pour le comparateur (23).

3. Système de mesure de la position selon la revendication 1 ou 2, caractérisé en ce qu'une valeur correspondant à la fraction incrémentale de l'échelle de mesure entre le point de mis en marche du système de lecture de l'extrémité de division suivante de l'échelle est mémorisée dans la mémoire de valeur désirée du dispositif de contrôle (23).

4. Système de mesure de la position selon la revendication 3, caractérisé en ce que la mémoire de valeur désirée peut recevoir au moyen du dispositif de contrôle (23) dans des conditions de fonctionnement prédéterminées, plus particulièrement après l'apparition d'un nombre déterminé de commandes de correction (passage par zéro du signal de mesure) le contenu de la mémoire intermédiaire (22,28, resp.).

5. Système de mesure de la position selon la revendication 4, caractérisé en ce que la mémoire intermédiaire (22,28) est conçue comme formateur de la moyenne pour plusieurs comptages du compteur de correction (21).

6. Système de mesure de la position selon l'une des revendications 1 à 5, caractérisé en ce que le compteur de correction (21) est conçu comme compteur de dépassement dont le nombre d'étages compteurs correspond à la division électronique de l'échelle, donc au multiple des impulsions de mesure exprimant le nombre d'impulsions de comptage.

7. Système de mesure de la position selon l'une des revendications 1 à 6, caractérisé en ce que les étages correcteurs (24,25) permettant l'addition et l'enlèvement, respectivement, d'impulsions de comptage se trouvent devant l'étage détecteur de direction (25) dans les lignes de comptage d'impulsions.

8. Système de mesure de la position selon l'une des revendications 1 à 7, comprenant une échelle composée de plusieurs parties et deux unités de lecture déplacées l'une par rapport à l'autre en direction de l'échelle et contenant au moins deux dispositifs de lecture, les deux unités de lecture pouvant être alternativement mises en marche au moyen d'un inverseur qui met hors circuit l'unité de lecture respective passant sur la jonction entre les deux parties, caractérisé en ce que les positions de mémoire particulière associées respectivement dans la mémoire de valeur désirée (23) à chaque partie d'échelle (5,5a) et les positions de mémoire associées à une partie d'échelle peuvent être connectées au dispositif comparateur (22,23) sous le contrôle de l'inverseur (10).

9. Système de mesure de la position selon la revendication 8, caractérisé en ce que les positions de mémoire particulière associées dans la mémoire de valeur désirée à chaque partie d'échelle (5, 5a) pour les deux directions de lecture peuvent être connectées au dispositif comparateur (22,23) pour le dispositif de lecture respectif.

# FIG.1

# FIG.2

# FIG.3

# FIG.4